Europäisches Patentamt

European Patent Office

Office européen des brevets

(19)

(11) Numéro de publication: **0 072 759**
**B1**

(12) **FASCICULE DE BREVET EUROPEEN**

(45) Date de publication du fascicule du brevet: **29.01.86**

(51) Int. Cl.⁴: **H 01 L 23/52,** G 06 K 19/06

(21) Numéro de dépôt: **82401536.6**

(22) Date de dépôt: **13.08.82**

(54) Module électronique pour carte de transactions automatiques et carte équipée d'un tel module.

(30) Priorité: **14.08.81 FR 8115767**

(43) Date de publication de la demande:
**23.02.83 Bulletin 83/08**

(45) Mention de la délivrance du brevet:
**29.01.86 Bulletin 86/05**

(84) Etats contractants désignés:
**AT BE CH DE GB IT LI LU NL SE**

(56) Documents cités:
**EP-A-0 019 280**
**EP-A-0 029 785**
**FR-A-2 337 381**
**FR-A-2 439 438**
**US-A-3 777 221**

(73) Titulaire: **ELECTRONIQUE SERGE DASSAULT**
**80, avenue Marceau**
**F-75008 PARIS (FR)**

(72) Inventeur: **Chlabovitch, Michel**
**48 G4 Avenue Eglé**
**F-78600 Maisons-Laffitte (FR)**

(74) Mandataire: **Ramey, Daniel et al**
**Cabinet NETTER 40, rue Vignon**
**F-75009 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

La présente invention a pour objet un module électronique notamment pour cartes de transactions automatiques, telles que des cartes de crédit, cartes de transactions bancaires, cartes de paiement de prestations diverses, par exemple pour frais de parc automobile, appels téléphoniques, etc.

On voit se répandre depuis quelques années les applications de telles cartes que l'on désignera ci-après, d'une manière générale, cartes de transactions automatiques. Elles sont destinées à commander ou autoriser le fonctionnement d'un dispositif d'exploitation dans lequel elles sont introduites en vue de rendre au porteur de la carte un service ou d'accomplir toute autre opération mettant en jeu des informations électroniques portés par cette carte.

Ces cartes qui ont d'abord vu le jour sous la forme de cartes de crédit ont un format portefeuille standardisé, en longueur, largeur et épaisseur. En outre, elles doivent répondre à des conditions de flexibilité prédéterminées.

A l'origine, ces cartes comportaient simplement une identification de leur objet, par exemple, carte de crédit au nom de telle Compagnie, et du porteur avec son adresse, ces dernières informations étant imprimées, par exemple par embossage de façon à pouvoir être facilement reproduites, et une capacité de mémoire électronique essentiellement sous la forme d'une ou plusieurs pistes magnétiques.

Plus récemment, on a vu apparaître des cartes qui, à la place, ou en plus de mémoires à pistes magnétiques, comprennent un module électronique capable, non seulement de mémoriser des quantités d'informations importantes mais également, de participer à l'inscription, à la lecture et au traitement de ces informations.

Ces modules électroniques sont mieux adaptés que les pistes magnétiques pour combattre des tentatives de fraude. Ils mettent en oeuvre des circuits intégrés dans des pastilles de semiconducteurs, en général appelées puces dont les dimensions sont très réduites.

Toutefois, la nécessité de connecter ces circuits intégrés à des dispositifs d'exploitation externes à la carte implique leur raccordement à des plots d'accès de dimensions suffisamment grandes pour permettre aux broches d'un appareil d'exploitation d'établir un contact électrique fiable avec ces plots. Pour cette raison, les modules électroniques actuellement disponibles sur le marché ou proposés pour équiper des cartes de transactions automatiques ont des dimensions encore trop importantes, soit en épaisseur, pour se loger à l'intérieur d'une carte de matière plastique standardisée sans provoquer de surépaisseur, soit dans le plan de la carte pour éviter d'introduire une zone de rigidité inadmissible et satisfaire ainsi aux tests de flexibilité de ces cartes.

Enfin, la dimension de ces modules avec leurs plots de connexion est encore telle qu'il peut s'avérer difficile de leur réserver un espace suffisant dans des cartes normalisées, compte tenu des espaces déjà prévus pour les autres formes d'enregistrement de données, que ces dernières soient magnétiques ou photographiques, ou consistent en inscriptions telles que signature, caractères d'impression en relief, identification de la carte et, éventuellement, indications de certaines conditions d'utilisation.

On connaît d'après la Demande de Brevet EP—A—0 019 280 un module électronique pour une carte de transactions automatiques standardisée, ledit module étant du type comprenant une puce de circuit intégré, des plots d'accès électrique au module et une structure d'interconnexion entre ces plots et la puce, ladite structure d'interconnexion étant réalisée en association avec une plaquette au-dessus de laquelle sont montés lesdits plots et qui est percée d'au moins une fenêtre dans l'épaisseur de laquelle est montée la puce. Les plots d'accès électrique sont disposés en deux rangés parallèles de ladite fenêtre, ladite plaquette étant réalisée sur une base de matériau rigide.

L'invention vise un module électronique propre à répondre aux diverses conditions précédemment énumérées, notamment pour permettre son utilisation dans une carte de transactions automatiques standardisées.

Elle concerne plus particulièrement, conformément à la revendication 1, un module du type défini précédemment et elle se caractérisé en ce que la structure d'interconnexion comprend une superstructure d'interconnexion à plusieurs niveaux réalisée en couches épaisses sur la base, une pluralité de plots de liaison en bordure de ladite fenêtre, en contrebas de ladite superstructure, ces plots de liaison étant reliés à des contacts sur la face supérieure de la puce logée dans cette fenêtre par des connexions formant une nappe de liaison à un niveau inférieur à celui des plots d'accès électrique et de la face supérieure de la structure d'interconnexion.

Ces interconnexions du module de l'invention sont réalisées par croissance, à partir de la base de matériau rigide, de couches conductrices séparés par des couches isolantes pour former des liaisons électriques sur plusieurs niveaux selon la technologie connue sous le nom de couches épaisses. Elles font donc partie d'une superstructure sur une des faces de de la plaquette de matériau rigide, au sommet de laquelle apparaissent les plots d'accès à la carte.

On parvient ainsi à réaliser des interconnexions relativement complexes dans une épaisseur très faible, largement compatible avec l'intégration du module équipé de cette plaquette de matériau rigide à l'intérieur d'une fenêtre dans la carte de matière plastique et à son maintien à l'intérieur de celle-ci sans provoquer de surépaisseur.

Selon une autre caractéristique de l'invention, le matériau rigide de la base est une céramique.

Les plaquettes de céramique ainsi obtenues présentent l'intérêt de se prêter à la fabrication en très grande série de structures d'interconnexion multicouches, grâce à des techniques de fabrication par répétition (repeat) dans lequelles chaque étape de la constitution du circuit d'interconnexion est reproduite simultanément à un très grand nombre d'exemplaires sur une plaque de céramique de grande dimension pour former plusieurs dizaines, voire centaines de circuits juxtaposés qui sont ultérieurement découpés.

La technologie de fabrication en couches épaisses sur une structure céramique, permet d'obtenir des superstructures d'interconnexion complexes sur une superficie réduite, ce qui aboutit à une double conséquence: il est possible de produire un très grand nombre de tels circuits juxtaposés sur une plaque de céramique de dimension donnée, ce qui est favorable à un coût de production faible; on parvient en outre à minimiser la surface totale d'un module constitué par l'association d'une ou plusieurs puces du circuit intégré et d'une structure d'interconnexion de façon à diminuer la surface du module. Ceci présente des avantages tant sur le plan du respect des normes de flexibilité imposées pour les cartes, que sur la possibilité de loger le module dans une zone de la carte où il n'interfère pas avec des inscriptions ou d'autres parties fonctionnelles.

Enfin, les plaquettes de céramique constituent un support rigide capable de supporter des efforts de pression importants qui peuvent être exercés par des broches de contact amenées en appui direct contre les plots d'accès externe du module, permettant ainsi une bonne qualité de contact électrique sans risque de déformation du module et de la carte à l'intérieur duquel il est logé.

Conformément à un autre aspect de l'invention, on prévoit d'utiliser une plaquette support, de préférence en céramique, pour former l'armature d'un module électronique en ménageant à l'intérieur de cette plaquette, au moins une fenêtre dans laquelle est montée une puce de circuit intégré sur une pastille de semi-conducteur dont l'épaisseur est sensiblement égale ou inférieure à celle de la plaquette support. Cette plaquette porte une structure d'interconnexion entre les plots d'accès au module et la puce de circuit intégré. De préférence, cette structure d'interconnexion comprend une superstructure multicouche sur une face de cette plaquette pour interconnecter en volume les plots d'accès et les plots de liaison à la puce disposés sur la plaquette en bordure de ladite fenêtre et en contrebas de cette superstructure. Des connexions formant une nappe liaison sont alors de préférence établies entre les lots bordure de cette fenêtre et des contacts correspondants de la puce. Il est notamment possible de réaliser une telle nappe de connexions de manière que leur niveau supérieur ne dépasse pas celui de la superstructure d'interconnexion adjacente afin de conserver au module une épaisseur qui n'est guère supérieure à celle de la plaquette de céramique avec sa superstructure d'interconnexion.

Selon une forme d'exécution de ce mode de réalisation, les connexions de liaison sont réalisées à l'aide d'une technologie de connexion T. A. B. (Transfert Automatique de Bande ou Tape Automated Bonding). Selon une autre forme d'exécution, on utilise des conducteurs à ruban ou a fil rond pour la réaliser.

Dans la structure qui vient d'être évoquée, on prévoit avantageusement de recouvrir la puce d'une couche de protection notamment contre l'action des rayons ultra-violets, sur une épaisseur telle que le niveau de cette couche ne dépasse pas la surface supérieure des superstructures.

En utilisant cette technologie on peut réaliser des structures particulièrement compactes en disposant les plots d'accès externes au module selon deux lignes parallèles de part et d'autre d'une ou plusieurs fenêtres dans lesquelles sont logées des puces du circuit intégré de la manière qui vient d'être indiquée.

Grâce à ces dispositions, on a pu développer un module électronique monolithique d'environ 600 µm d'épaisseur et de 12×15 mm hors tout, comprenant une puce de mémoire et une puce de microprocesseur, parfaitement adapté à son emploi dans une carte de transactions automatiques.

Les explications et la description à titre d'exemple d'un mode de réalisation et qui suivent sont faites en référence aux dessins annexés, sur lesquels:

— la figure 1 représente une carte de paiement utilisant un module électronique selon l'invention;
— la figure 2 illustre l'implantation de ce module dans la carte;
— les figures 3 et 4 illustrent deux modes d'organisation d'un module électronique selon qu'il comporte respectivement une ou deux puces de circuit intégré;
— la figure 5 est une vue détaillée de dessus d'un module électronique selon l'invention;
— la figure 6 est une vue en coupe transversale de ce module intégré dans une carte de transactions, selon une ligne VI—VI de la figure 5.

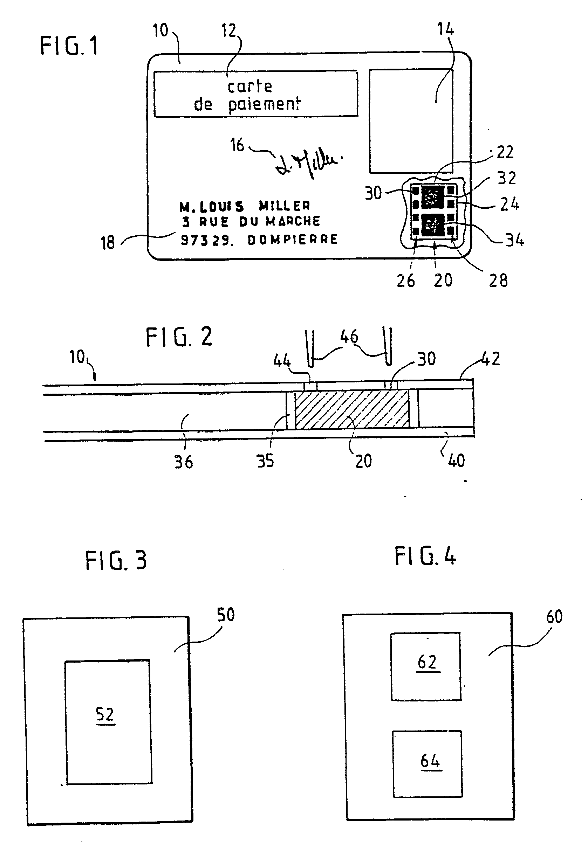

Une carte de paiement standardisée 10 (figure 1) est réalisée en une matière plastique d'épaisseur totale 760 µm de largeur 54 mm et de longueur 85 mm (norme ISO). Elle porte sur sa face antérieure un emplacement 12 pour l'identification de son objet, un emplacement 14 dans le coin supérieur droit pour la photo de son titulaire, un emplacement 16 pour sa signature, un emplacement 18 en bas, à gauche, permettant l'impression par embossage du nom et de l'adresse du titulaire. Le coin inférieur droit de la carte permet d'apercevoir en écorché, un module électronique 20 monté dans l'épaisseur de la carte et qui sera décrit ci-après plus en détail. Parallèlement à la longueur de cette carte et au dos de cette dernière, sont disposées des pistes d'enregistrement magnétiques qui occupent toute la moitié supérieure de la carte.

Le module électrique 20 a une largeur 22 d'environ 12 mm sur une longueur 24 de 15 mm. Sa face supérieure fait apparaître deux rangées 26 et 28 de 4 plots 30 chacune, de forme carrée et accessible de l'extérieur de la carte pour entrer en contact avec des broches d'un appareil, par exemple un terminal pour l'établissement et le paiement de communications téléphoniques. Entre les deux rangées 26 et 28 le circuit laisse apparaître deux plaques sombres 32 et 34 alignées parallèlement à la direction des rangées 26 et 28 de plots 30 et correspondant chacune à l'emplacement d'une puce de circuit électronique intégré, comme il sera expliqué ci-après.

Le module 20 a la forme d'un rectangle plat d'environ 600 µm d'épaisseur (figure 2). Il est logé dans une fenêtre 35 ménagée dans le substrat plastique 36 de la carte 10, de même épaisseur, l'ensemble étant recouvert sur chacune de ses faces d'un film thermo-plastique, respectivement 40 et 42, appliqué à chaud sous pression qui maintient le module 20 en place dans la fenêtre 35. Les films 40 et 42 ont une épaisseur d'environ 80 µm chacun. Le film 42 comporte des encoches 44 à l'emplacement de chaque plot 30 pour permettre l'accès à ces derniers de broches de contact telles que 46 d'un appareil extérieur.

Sur les figures 3 et 4 on a représenté, vues de dessus, deux plaquettes céramiques respectivement 50 et 60, d'épaisseur 400 µm et percées respectivement d'une fenêtre rectangulaire 52 dans le cas de la plaquette 50 et de deux fenêtres carrées identiques 62 et 64 dans le cas de la figure 4, chacune de ces fenêtres étant propre à recevoir une puce de circuit intégré de forme correspondante et d'épaisseur de 300 à 450 µm et par exemple égale à 400 µm. Le fenêtre 52 (figure 3) permet de loger, par exemple, une puce de micro-processeur avec une mémoire intégrée (monochip). Les fenêtres 62 et 64 (figure 4) ont des dimensions d'environ 5 mm×5 mm et permettent, par exemple, de loger repectivement une puce de micro-processeur Motorola 6805 et une puce de mémoire Intel 2716 (marques déposées).

Les plaquettes de céramique 50 et 60 constituent l'armature de modules électroniques telle que 20 (figures 1 et 2) pour une carte de transactions, selon l'invention. Elles permettent d'assurer à la fois le montage des puces de circuits intégrés, et les interconnexions entre ces derniers et les plots d'accès 30 par une technique d'interconnexion en volume obtenue par croissance de couches multiples à partir du substrat de céramique selon la technologie des couches épaisses.

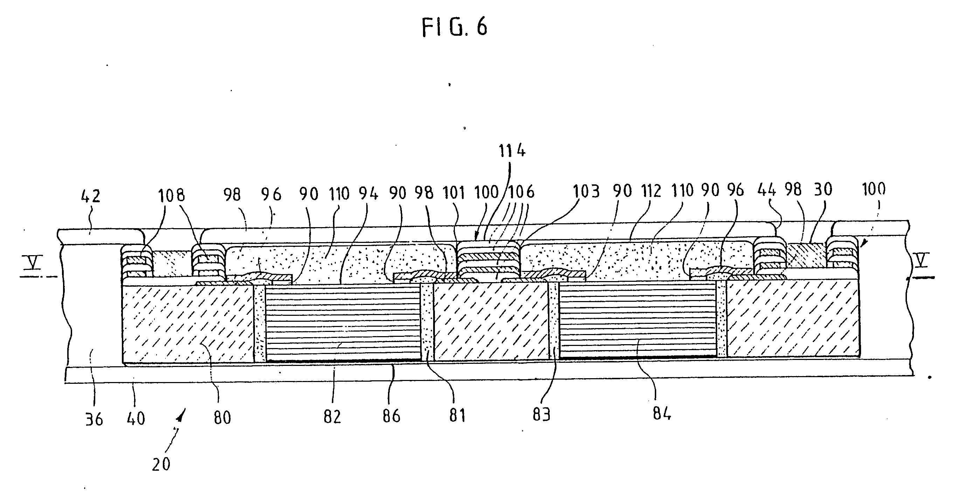

La structure d'un module électronique 20 comprenant deux puces de circuits intégrés 82 et 84 logées dans des fenêtres respectives 81 et 83 d'une plaquette de céramique 80 identique à la plaquette 60 de la figure 4 et bien visible sur la figure 6. Sur leurs faces inférieures, la plaquette de céramique 80 et les puces 82 et 84 sont reliées par une couche de cuivre 86 formant plan de masse et plan thermique et collée à la céramique, immédiatement au-dessus du film thermo-plastique 40.

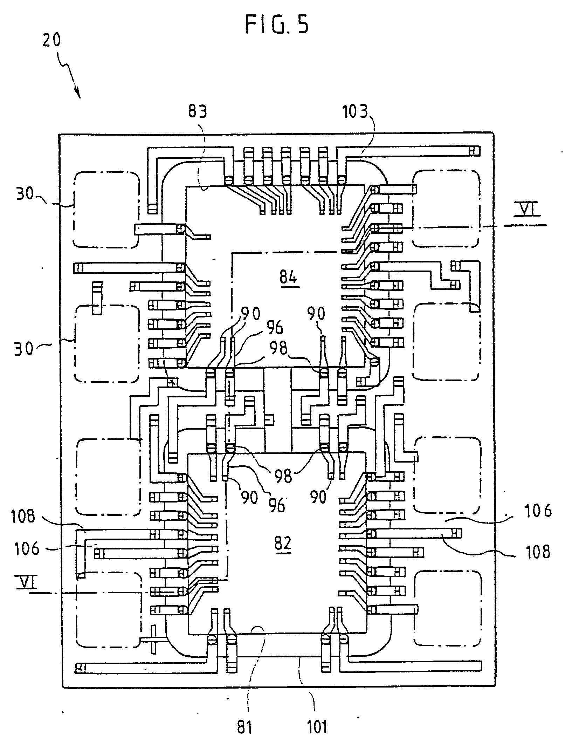

Les contacts de branchement 90 des puces 82 et 84 constituent dans cet exemple de légères bosses à la surface supérieure des puces et sont reliées par des conducteurs plats tels que 96 à des plots correspondants 98 à la surface supérieure de la plaquette de céramique 80 en bordure des fenêtres respectives. Les bornes 90, les plots 98, et les conducteurs plats 96 sont bien visibles sur la figure 5 qui représente le module vu dans un plan V—V (figure 6) légèrement au-dessus de la surface supérieure de la plaquette et des puces 82, 84. Dans cet exemple, il y a 24 plots 98 de liaison à la puce 82 et 28 plots de liaison à la puce 84.

Les puces 82 et 84 viennent se loger étroitement dans les fenêtres de forme correspondante 81 et 83. Autour de chacune de ces fenêtres on a représenté les bords d'une cuvette respective 101 et 103 définie par une superstructure d'interconnexion 100 entourant chacune des ouvertures 81 et 83, en retrait par rapport aux plots 98 répartis autour de ces ouvertures qui se trouvent donc en contrebas de la superstructure 100. On a également représenté en tirets les projections des plots 30 dans le plan de la figure 5.

La superstructure d'interconnexion 100 est bien visible en coupe sur la figure 6. Elle est composée d'une superposition de couches isolantes en verre telles que 106, et de couches conductrices, en or ou autre matériau convenable, en lames telles que 108 dont les tracés permettent d'établir les interconnexions entre les plots externes 30 d'une part, et les plots 98 de connexion des puces d'autre part. Les tracés des couches conductrices en or qui se trouvent dans le plan V—V sont bien visible sur la figure 5. Elles sont séparées des autres lames conductrices dans leur plan et dans les plans de niveaux différents par les couches isolantes de verre 106. Les couches ou lames conductrices 108 de niveau différent sont réunies sélectivement par des trous ou passages remplis de substance conductrice à travers les couches isolantes 106 de séparation. Cette technique d'interconnexion en volume permet de réunir électriquement les nombreux plots 98 en bordure des ouvertures 81 et 83 aux plots de contact externes 30 dans un encombrement réduit, et limité dans le plan par le contour extérieur de la plaquette 20 et les contours des cuvettes 101 et 103, tout en permettant les croisements indispensables à l'exécution des connexions recherchées.

La réalisation de la structure d'interconnexion en volume 100 est obtenue avec une excellente précision par la mise en oeuvre d'une technologie de croissance en couches épaisses. Ces techniques sont bien connues, qui permettent à partir d'un substrat de céramique de déposer par sérigraphie, des liaisons conductrices ou résistives, ces encres étant stabilisées par une cuisson en haute température, et de les recouvrir de substances isolantes en couches dans lesquelles on laisse subsister des trous aux emplacements appropriés aux liaisons conductrices perpendiculaires.

Les plaquettes de céramique 80 et leurs superstructures d'interconnexion respectives 100 peuvent être obtenues en très grand nombre par des techniques de répétitions (repeat) dans lesquelles on forme sur une plaquette de grande dimension en céramique un grand nombre de structures d'interconnexion individuelles pouvant aisément atteindre 60 ou 80 dans les cas des modules selon l'invention. Les plaquettes individuelles 80 peuvent être percées de part en part, par exemple par laser, pour constituer les fenêtres 81 et 83 et découpées lorsque la constitution des superstructures d'interconnexion est terminée. Grâce à leur très petite dimension, ces plaquettes peuvent être obtenues simultanément en grand nombre à partir de chaque opération de croissance, ce qui contribue à en abaisser le prix de revient.

Le montage des puces 82 et 84 dans les plaquettes 80 et leur connexion aux plots 98 peuvent être avantageusement exécutés de façon entièrement automatique à l'aide d'une technique de transfert automatique de bande (T.A.B.). Ces techniques connues permettent après avoir fait croître au niveau de chaque contact de la puce une petite bosse conductrice 90, d'appliquer sur ces bosses des conducteurs respectifs tenus ensemble par un film. Chaque puce individuelle peut être prélevée à partir de la tranche de semi-conducteur dans lequel elle a été fabriquée à l'aide de ce film et être insérée dans l'ouverture correspondante de la plaquette de céramique 80, l'adhésion des bandes conductrices 96 liées au film étant effectuée par compression à chaud contre les plots 98 correspondants. Cette technique permet de tester aisément le circuit intégré.

Selon une variante de réalisation, on remplace la connexion par transfert automatique de bande en réalisant les liaisons 96 par des rubans plats ou des fils ronds, en or ou en aluminium, qui sont appliqués simultanément par thermo-compression aux contacts 90 et aux plots 98 après la mise en place des puces dans les ouvertures correspondantes.

Lorsque les puces 82 et 84 ont été rapportées dans la plaque de céramique 80, leur surface supérieure et celle des connexions 96 se trouvent à l'intérieur de cuvettes 101 et 103 définies par les bords de la superstructure d'interconnexion 100 et en contrebas de celle-ci. Ces cuvettes sont alors remplies d'une couche de matériau opaque aux ultra-violets, par exemple une résine époxy polymérisable 110, dont la surface supérieure 112 vient affleurer avec la surface supérieure 114 de la superstructure d'interconnexion 100. Cette résine remplit les interstices entre la puce de circuit intégré et les bords de l'ouverture respective dans la plaquette de ceramique 80. Elle protège la puce mécaniquement et chimiquement contre les actions extérieures.

L'épaisseur de la structure d'interconnexion 100 au-dessus de la surface supérieure de la plaquette de céramique 80 est d'environ 150 μm.

Les liaisons plates 96 ont une hauteur de 60 à 70 μm et sont recouvertes d'un enrobage 110 dont l'épaisseur est d'environ 80 à 90 μm. Le plan de masse 86 a une épaisseur d'environ 50 μm. L'épaisseur totale du module ainsi obtenue est donc de 600 μm. Sa surface est environ deux fois plus petite que celle de circuits déjà proposés pour des applications similaires. Elle est compatible avec les normes de flexibilité de cartes de transactions automatiques ainsi qu'avec les normes d'implantation d'informations sur ces cartes déjà existantes.

Les plots 30 se trouvent du côté du support multicouche, auquel ils appartiennent et avec lequel ils sont formés, la disposition des lignes de plots de part et d'autre de la ou des puces de circuits intégrés utilisés permet d'obtenir une structure à la fois compacte et solide.

Outre l'avantage de compacité mentionné ci-dessus, la rigidité de la céramique permet de supporter des efforts de pression importants pour établir des contacts de bonne qualité entre les plots 30 et des broches d'un appareil d'exploitation externe abaissées perpendiculairement à ces plots. Il n'est donc pas indispensable de prévoir des contacts glissants.

**Revendications**

1. Module électronique pour une carte de transactions automatiques standardisée, ledit module étant due type comprenant une puce de circuit intégré (82; 84), des plots d'accès électrique (30) au module (20) et une structure d'interconnexion entre ces plots et la puce, cette structure d'interconnexion étant réalisée en association avec une plaquette (80; 100) au-dessus de laquelle sont montés lesdits plots (30) et qui est percée d'au moins une fenêtre (81; 83) dans l'épaisseur de laquelle est montée la puce (82; 84), les plots d'accès électrique (30) étant disposés en deux rangées parallèles de part et d'autre de ladite fenêtre (81; 83), ladite plaquette (80, 100) étant réalisée sur une base de matériau rigide, caractérisé en ce que la structure d'interconnexion comprend une superstructure (100) d'interconnexion à plusieurs niveaux réalisée en couches épaisses sur la base (80), une pluralité de plots de liaison (98) en bordure de ladite fenêtre (81, 83), en contrebas de ladite superstructure (100), ces plots de liaison (98) étant reliés à des contacts (90) sur la face supérieure de la puce (82; 84) logée dans cette fenêtre (81; 83) par des connexions formant une nappe de liaison (96) à un niveau inférieur à celui des plots d'accès électrique (30) et de la face supérieure de la superstructure d'interconnexion (100).

2. Module selon la revendication 1, caractérisé en ce que le matériau rigide de la base (80) est une céramique.

3. Module selon l'une des revendications 1 et 2, caractérisé en ce que la puce (82; 84) et les bords de la fenêtre (81; 83) sur lesquels sont disposés les plots de liaison (98) à la puce, sont revêtus d'une couche de protection (110) dont la face supérieure ne dépssse pratiquement pas le niveau de celle de la superstructure d'interconnexion (100).

4. Module selon la revendication 3, caractérisé en ce que la nappe (96) est noyée dans ladite couche de protection (110).

5. Module selon l'une des revendications 1 à 4, caractérisé en ce que ladite nappe est réalisée par une technologie de transfert automatique de bande.

6. Module selon l'une des revendications 1 à 4, caractérisé en ce que ladite nappe (96) est réalisée à l'aide de rubans ou fils conducteurs.

7. Module selon l'une des revendications précédentes, caractérisé en ce que la face inférieure de la puce (82; 84) est revêtue d'un plan de masse (86) qui s'étend à la plaquette formant la structure d'interconnexion.

8. Module selon l'une des revendications précédentes, caractérisé en ce que son épaisseur est inférieure ou égale à 600 micromètres et/ou ses dimensions en plan sont inférieures ou égales à 12×5 mm.

9. Carte flexible normalisée pour transactions automatiques, caractérisée en ce qu'elle comprend une fenêtre dans l'épaisseur de laquelle est logé un module selon l'une des revendications 1 à 8.

**Patentansprüche**

1. Elektronischer Modul für eine standardisierte Karte für automatische Transaktionen, der einen IC- Chip (82, 84) aufweist sowie Kontaktstellen (30) für den elektrischen Zugang zum Modul (20) und eine Verbindungsanordnung zwischen diesen Kontaktstellen und dem Baustein aufweist, wobei die Verbindungsanordnung in Zusammenhang mit einem Plättchen (80, 100) ausgebildet ist, oberhalb dessen die Kontaktstellen (30) angeordnet sind und das von wenigstens einem Fenster (81, 83) durchsetzt ist, in die der Chip (82, 84) vollständig eingesetzt ist, wobei die Kontaktstellen (30) für den elektrischen Zugang in zwei parallelen Reihen beidseits des Fensters (81, 83) angeordnet sind und das Plättchen (80, 100) auf einem Grundteil aus steifem Material hergestellt ist, dadurch gekennzeichnet, daß die Verbindungsanordnung eine Überlagerungsstruktur (100) mit verschiedenen Ebenen aufweist in Form von Dickschichten auf dem Grundteil (80) sowie eine Vielzahl von Verbindungskontakten (98) am Rand des Fensters (81, 83) unterhalb der Überlagerungsstruktur (100) aufweist, wobei diese Verbindungskontakte mit Kontakten (90) auf der oberen Fläche des im Fenster (81, 83) eingesetzten Chips (82, 84) mittels Leitungen verbunden sind, die ein Leitungsmuster (96) bilden in einer Ebene unterhalb derjenigen der Kontaktstellen (30) für den elektrischen Zugang und unterhalb der oberen Fläche der Überlagerungsstruktur (100).

2. Modul nach Anspruch 1, dadurch gekennzeichnet, daß das steife Material des Grundteils (80) aus Keramik besteht.

3. Modul nach einem der Ansprüche 1 und 2, dadurch gekennzeichnet, daß der Chip (82, 84) und die Ränder des Fensters (81, 83), auf denen die Verbindungskontakte (98) zum Chip angeordnet sind, mit einer Schutzschicht (110) bedeckt sind, deren Oberfläche praktisch nicht über die Ebene derjenigen der Überlagerungsstruktur (110) hinausragt.

4. Modul nach Anspruch 3, dadurch gekennzeichnet, daß das Muster (96) von der Schutzschicht (110) bedeckt ist.

5. Modul nach einem der Ansprüche 1 bis 4, dadurch gekennzeichnet, daß das Muster mittels der Technik des Automatischen Filmbondens hergestellt ist.

6. Modul nach einem der Ansprüche 1 bis 4, dadurch gekennzeichnet, daß das Muster (96) mittels Leiterbahnen oder Leiterdrähten hergestellt ist.

7. Modul nach einem der vorhergehenden Ansprüche, dadurch gekennzeichnet, daß die untere Fläche des Chips (82, 84) mit einer Massenebene (86) beschichtet ist, die sich an dem Plättchen erstreckt, in dem die Verbindungsanordnung ausgebildet ist.

8. Modul nach einem der vorhergehenden Ansprüche, dadurch gekennzeichnet, daß seine Dicke kleiner oder gleich 600 μm ist und/oder daß seine ebenen Abmessungen kleiner oder gleich 12×5 mm sind.

9. Standardisierte flexible Karte für automatische Transaktionen, dadurch gekennzeichnet, daß sie ein Fenster aufweist, in das ein Modul nach einem der Ansprüche 1 bis 8 vollständig eingesetzt ist.

**Claims**

1. An electronic module for a standardized automatic transaction card, said module being of the type comprising an integrated circuit chip (82, 84), contact studs (30) for electrical access to the module (20) and an interconnection structure between these studs and the chip, this interconnection structure being realised in association with a base plate (80, 100) above which said studs (3) are mounted and which is pierced by at least one window (81, 83), in the thickness of which the chip (82, 84) is mounted, the electrical access studs (30) being disposed in two parallel rows, one at each side of said window (81, 83), said base plate (80, 100) being constructed on a base of rigid material, wherein the interconnection structure comprises a multi-level interconnection superstructure (100) made in thick layers on the base (80), a plurality of terminal pads (98) along the edge of said window (81, 83), below said superstructure (100), said terminal pads (98) being connected to pads (90) on the upper face of the chip (82, 84) housed in this window (81, 83) by an array of connecting links (96) at a lower level than that of the electrical access studs (30) and of the upper face of the interconnection superstructure (100).

2. A module as claimed in Claim 1, wherein the rigid material of the base (80) is a ceramic.

3. A module as claimed in Claim 1 or Claim 2, wherein the chip (82, 84) and the edges of the window (81, 83) on which the terminal pads (98) to the chip are disposed, are covered with a protective layer (110), the upper face of which is not substantially higher than the level of the interconnection superstructure (100).

4. A module as claimed in Claim 3, wherein the link array (96) is embedded in said protective layer (110).

5. A module as claimed in any of Claims 1 to 4, wherein the link array (96) is produced by tape automated bonding technology.

6. A module as claimed in any of Claims 1 to 4, wherein the link array (96) is formed of conducting strips or wires.

7. A module as claimed in any of the preceding claims, wherein the lower face of the chip (82, 84) is covered with an earth plane (86) which extends as far as the base plate forming the interconnection structure.

8. A module as claimed cn any of the preceding claims, wherein the module thickness is less than or equal to 600 micrometres and/or its dimensions in plan are less than or equal to 12×5 mm.

9. A flexible standardized automatic transaction card comprising a window in the thickness of which is housed an electric module as claimed in any of the Claims 1 to 8.

0 072 759

FIG.1

10    12    14

carte
de paiement

16    ℒ. Miller.

22
32
30    24
34

M. LOUIS MILLER
3 RUE DU MARCHE
18    97329. DOMPIERRE

26    20    28

FIG. 2

46
10    44    30    42

36    35    20    40

FIG. 3

50

52

FIG. 4

60

62

64

1

FIG. 5

0 072 759

2

# FIG. 6

0 072 759